# EUROPÄISCHE PATENTSCHRIFT

(11) **EP 0 475 378 B1**
(45) Veröffentlichungstag und Bekanntmachung des Hinweises auf die Patenterteilung: **07.01.1998**
(21) Anmeldenummer: 91115340.1
(22) Anmeldetag: 11.09.1991
(51) Int. Cl.: H01L 21/20, H01L 21/76

(54) **Verfahren zur Herstellung von Substraten für elektronische, elektrooptische und optische Bauelemente**
Process for making substratus for electronic, electro-optic and optical devices
Procédé de fabrication de substrats pour composants optiques, électroniques et électro-optiques

(30) Priorität: 13.09.1990 DE 4029060
(43) Veröffentlichungstag der Anmeldung: 18.03.1992
(73) Patentinhaber: FORSCHUNGSZENTRUM JÜLICH GMBH, 52425 Jülich (DE)
(72) Erfinder: Mantl, Siegfried, Dr., W-5170 Jülich (DE); Holländer, Bernd, Dr., W-5090 Leverkusen 1 (DE); Butz, Rainer, Dr., W-5172 Linnich (DE)

(56) Entgegenhaltungen:
- DE-A- 3 743 734
- US-A- 4 357 183
- US-A- 4 819 037
- APPLIED PHYSICS LETTERS. Bd. 53, Nr. 8, 22. August 1988, NEW YORK US Seiten 669 - 671; VAN HOMMEN ET AL: 'Synthesis of heteroepitaxial Si/CoSi2/Si structures by Co implantation into Si'
- JAPANESE JOURNAL OF APPLIED PHYSICS, SUPPLEMENTS. 19TH CONF. ON SOLID STATE DEVICES AND MATERIALS, TOKYO, 25-27 AUGUST 1987 TOKYO JA Seiten 151 - 154; KIMURA ET AL: 'The growth of GaAs on recrystallized Ge/SiO2/GaAs'
- JAPANESE JOURNAL OF APPLIED PHYSICS, SUPPLEMENTS. 21TH CONF. ON SOLID STATE DEVICES AND MATERIALS, TOKYO 28-30 AUGUST 1989 TOKYO JA Seiten 185 - 188; TOMOZANE ET AL: 'Reduction of threading dislocations and oxides precipitates in SIMOX material'
- Nuclear Instruments and Methods in Physics Research, B 84, 1994, S. 218-221
- Journal Applied Physics 75, 1994, S. 7240-7246
- Applied Physics Letters, 64, 1994, S. 1856-1858
- Proceedings of the International Conference INFOS 85, 16-18/04/85, S. 41-49
- Journal Of Electronic Materials, Band 20, No. 3 1991 S. 267-277

## Beschreibung

Die Erfindung bezieht sich auf ein Verfahren zur Herstellung von Schichtstrukturen für mikroelektronische Bauelemente, bestehend aus einkristallinem Substrat mit vergrabener, amorpher Schicht und darauf befindlicher einkristalliner Schicht. Die Erfindung bezieht sich ferner auf ein Verfahren zur Herstellung von Schichtstrukturen für mikroelektronische Bauelemente, bestehend aus einkristallinem Substrat mit vergrabener, amorpher Schicht und darauf befindlicher einkristallinen Schichten, wobei von einem einkristallinen Substrat mit vergrabener, amorpher Schicht und darauf befindlicher einkristalliner Schicht ausgegangen wird.

Häufig wird die Herstellung einkristalliner Filme durch das zur Verfügung stehende Substratmaterial stark begrenzt bzw. die Qualität der Filme vermindert. Unterschiedliche Kristallstrukturen sowie unterschiedliche Gitterparamemter (Gitterfehlanpassung) zwischen Substrat und Schichtmaterial machen z.B. eine Epitaxie auf Si-Scheiben nur in ganz speziellen Fällen möglich. Werden bei nicht angepaßten Gitterparametern Schichten abgeschieden, hat dies zur Folge, daß bei Schichtdicken, die für Bauelemente häufig erforderlich sind, Versetzungen an der Grenzfläche eingebaut werden. Da sich die meisten dieser Versetzungen durch die neu gewachsene Schicht hindurch fortsetzen, verschlechtern sie die elektrischen und insbesondere die optischen Eigenschaften des Schichtmaterials erheblich. Alternative Verfahren, wie z.B. das Abscheiden auf porösem Si, waren bisher wenig erfolgreich.

Aus der US-A-4 819 037 ist ein Verfahren zum Herstellen einer integrierten Schaltung auf einem SIMOX-Substrat bekannt. Es wird ein Si-Substrat mit Sauerstoff implantiert und erwärmt, um eine amorphe, vergrabene SiO₂-Schicht zu erzeugen (SIMOX). Auf die obere Si-Schicht ist dann ein Metall, wie Nickel oder Cobalt, (oder ein Silicid, wie Cobalt oder Nickel-Silicid) deponiert. Nach einer Erwärmung wird eine epitaktische CoSi₂- oder NiSi₂-Schicht erhalten, die dem gewünschten kristallinen Film entspricht.

Aus Appl. Phys. Letters, Bd. 53, Nr. 8, 22, August 1988, S. 669 - 671, ist ferner bekannt, die zur Bildung eines Mischkristalls erforderlichen Komponenten durch Ionenimplantation in die einkristalline Schicht einzubringen. Dabei ist der Ionenimplantation eine Glühbehandlung nachgeschaltet.

Aufgabe der Erfindung ist es, ein Verfahren der eingangs bezeichneten Art zu schaffen, bei dem die eingangs angegebenen Nachteile weitgehend vermieden werden.

Diese Aufgabe wird erfindungsgemäß dadurch gelöst, daß die auf der amorphen Schicht befindliche einkristalline Schicht unter Hinzufügen einer Komponente vollständig in einen der gewünschten einkristallinen Schicht entsprechenden Mischkristall umgewandelt wird.

Die Aufgabe wird alternativ dadurch gelöst, daß die auf der amorphen Schicht befindliche einkristalline Schicht unter Hinzufügen einer Komponente vollständig in einen Mischkristall umgewandelt wird, dessen Gitterparameter denen der gewünschten einkristaliinen Schicht näher kommen als die Gitterparameter der in den Mischkristall umgewandelten kristallinen Schicht, wonach auf dem Mischkristall die gewünschte einkristalline Schicht abgeschieden wird.

Durch die erfindungsgemäße Umwandlung der einkristallinen Oberflächenschicht in einen Legierungskristall (Mischkristall) werden die nicht angepaßten Kristallgitter durch die amorphe Schicht getrennt und die Bildung eines Versetzungsnetzwerkes verhindert, da an der kristallin-amorphen Grenzfläche im Gegensatz zu nicht angepaßten Kristallstrukturen keine Kohärenzspannungen auftreten. Entweder ist die so hergestellte einkristalline Schicht bereits das gewünschte Produkt, die gewünschte Schicht oder sie bildet eine geeignete Basis (Pufferschicht) für das Aufwachsen einer weiteren einkristallinen Schicht, d.h., sie ist Keimschicht für das weitere einkristalline Wachstum der gewünschten einkristallinen Schicht.

Die Umwandlung der einkristallinen Oberflächenschicht kann auf verschiedene Weise durchgeführt werden. So ist es beispielsweise möglich, daß die zur Bildung des Mischkristalls erforderliche Komponente auf der einkristallinen Schicht deponiert wird und gleichzeitig oder anschließend eine Erwärmung der Schicht erfolgt, um durch thermische Diffusion und/oder chemische Reaktion eine Homogenisierung der kristallinen Schicht bzw. Bildung des Mischkristalls zu erzielen.

Eine alternative Verfahrensweise besteht darin, daß die zur Bildung des Mischkristalls erforderliche Komponente durch Ionenimplantation und Glühbehandlung in die einkristalline Schicht eingebracht wird, wobei die Glühbehandlung der lonenimplantation auch nachgeschaltet sein kann.

Bei dem sich bildenden Mischkristall (Legierungskristall) kann die Konzentration der Komponenten in Wachstumsrichtung sich ändern, wobei in einem nicht ideal gitterangepaßten System in der umgewandelten Schicht ein Gradient im Gitterparameter in Wachstumsrichtung entsteht.

Eine weitere, alternative Verfahrensweise zur Umwandlung der einkristallinen Schicht besteht darin, daß die zur Bildung des Mischkristalls erforderliche Komponente auf der einkristallinen Schicht mittels Epitaxie abgeschieden wird und während oder nach der epitaktischen Abscheidung der Komponenten eine Glühbehandlung vorgenommen wird.

Wie sich gezeigt hat, kann sich der Gitterparameter der umgewandelten Schicht wesentlich von dem des Substratmaterials unterscheiden, wobei sich eine höhere Kristallqualität als mit herkömmlichen Verfahren erreichen läßt. Aufgrund dessen weist diese Schicht eine höhere Temperaturbeständigkeit auf.

Durch die Verwendung eines Substrats mit einer elektrisch isolierenden, vergrabenen, amorphen Schicht (wie z.B. bei SIMOX-Wafern) ist die neue einkristalline Schicht zudem dielektrisch vom Substrat isoliert.- Damit weist das erfindungsgemäße Bauteil alle inhärenten Vorteile der SIMOX-Strukturen (isolation electronics) für mikroelektronische Anwendungen, wie z.B. Hochfrequenzverhalten, auf.

In der Zeichnung wird zur Verdeutlichung der erfindungsgemäßen Verfahrensweise in schematischen Darstellungen ein nach der bisherigen Verfahrensweise hergestellten Bauelement mit einem nach dem erfindungsgemäßen Verfahren hergestellten Bauelement verglichen.

Es zeigen:
- Figur 1: ein Bauelement, das nach dem bisherigen Verfahren mit Heteroepitaxie auf nichtgitterangepaßtem Substrat hergestellt wurde;
- Figur 2: ein nach dem erfindungsgemäßen Verfahren hergestelltes Bauelement.

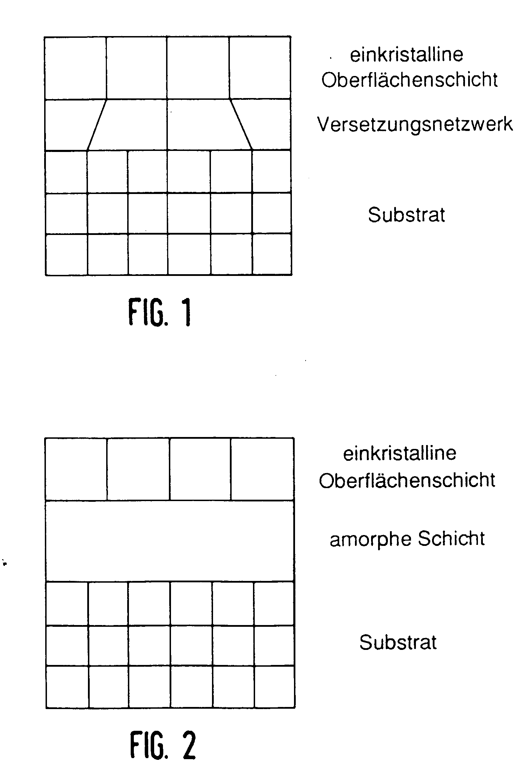

Wie aus Figur 1 zu ersehen ist, gelingt es nach dem bisherigen Verfahren nicht, auf dem Substrat eine einkristalline Oberflächenschicht, die gewünschte Schicht, ohne das Entstehen eines Versetzungsnetzwerkes abzuscheiden.

Bei dem in Figur 2 dargestellten Bauteil ist das einkristalline Substrat, das eine andere Gitterstruktur besitzt als die gewünschte Schicht, von der einkristallinen Oberflächenschicht durch eine amorphe Schicht getrennt. Ein Versetzungsnetzwerk tritt dabei nicht auf.

Ausführungsbeispiel 1:
Einkristalliner Si-Ge Mischkristall auf SiO₂ Isolationsschicht.

Als Substrat wurde ein SIMOX-Wafer (SIMOX = separation by implantation of oxygen) verwendet. Diese käuflichen Substrate bestehen aus einer Si-Scheibe mit einer vergrabenen, amorphen Siliciumdioxid-Schicht und einer einkristallinen Si-Oberflächenschicht.

Die Si-Oberflächenschicht wurde zunächst durch Plasmaätzen auf eine Dicke von ca. 20 nm abgedünnt. Das so präparierte Substrat wurde in einer Epitaxieanlage mittels Molekularstrahlepitaxie (MBE) - wie in der Si-Epitaxie üblich - gereinigt, um eine perfekte und saubere Oberfläche zu erhalten. Anschließend wurden bei 450°C Si und Ge im Verhältnis 80 : 20 abgeschieden. Durch nachfolgendes Tempern (1100°C, 30 s) wurde eine vollständige Homogenisierung der Si-Keimschicht und der aufgebrachten Si-Ge-Schicht erreicht.

Die so hergestellten Si-Ge-Schichten können entweder direkt verwendet werden oder als Zwischenschicht für weiteres epitaktisches Wachsum von Heterostrukturen und Übergittern dienen.

Ausführungsbeispiel 2:
Einkristallines Kobaltsilicid auf Siliciumdioxid.

Ausgangsmaterial war erneut eine Siliciumscheibe mit einer vergrabenen SiO₂-Schicht, ein SIMGX-Wafer.

Die einkristalline Si-Oberflächenschicht wurde erst chemisch gereinigt und mit Plasmaätzen auf die gewünschte Dicke abgedünnt. Anschließend wurde in einer Aufdampfanlage, unter Ultrahochvakuumbedingungen, das Co aufgedampft. Die Silicidbildung erfolgte in situ in der Anlage durch thermische Behandlung.

Die erzielbaren Schichtdicken hängen von dem gewählten System ab. Im vorliegenden Falle des CoSi₂ ergab eine 100 nm dicke Si-Ausgangsschicht mit einem aufgebrachten Co-Film von 28 nm Dicke nach Ablauf der Festkörperepitaxie eine Silicidschichtdicke von ebenfalls 100 nm. Die für ein vollständiges Durchreagieren der CoSi₂-Schicht erforderlichen Temperaturen und Anlaßzeiten betrugen ca. 600°C und 30 min.

Das so hergestellte Bauelement besaß eine einkristalline Silicidschicht hoher elektrischer und kristalliner Qualität auf einer elektrisch isolierenden SiO₂-Schicht.

## Patentansprüche

1. Verfahren zur Herstellung von Schichtstrukturen für mikroelektronische Bauelemente, bestehend aus einkristallinem Substrat mit vergrabener, isolierender, amorpher Schicht und darauf befindlicher einkristalliner Schicht, wobei von einem einkristallinen Substrat mit vergrabener, amorpher Schicht und darauf befindlicher einkristalliner Schicht ausgegangen wird
**dadurch gekennzeichnet,**
daß die ursprüngliche einkristalline Schicht unter Hinzufügen einer Komponente vollständig in einen der gewünschten einkristallinen Schicht entsprechenden Mischkristall umgewandelt wird.

2. Verfahren zur Herstellung von Schichtstrukturen für mikroelektronische Bauelemente, bestehend aus einkristallinem Substrat mit vergrabener, isolierender, amorpher Schicht und darauf befindlichen einkristallinen Schichten, wobei von einem einkristallinen Substrat mit vergrabener, isolierender amorpher Schicht und darauf befindlicher einkristalliner Schicht ausgegangen wird,
**dadurch gekennzeichnet,**
daß die auf der amorphen Schicht befindliche ursprüngliche einkristalline Schicht unter Hinzufügen einer Komponente vollständig in einen Mischkristall umgewandelt wird, dessen Gitterparameter denen der gewünschten einkristallinen Schicht näher kommen als die Gitterparameter der in den Mischkristall umgewandelten kristallinen Schicht, wonach auf dem Mischkristall die gewünschte einkristalline Schicht abgeschieden wird.

3. Verfahren nach Anspruch 1 oder 2,
**dadurch gekennzeichnet,**
daß die zur Bildung des Mischkristalls erforderliche Komponente auf der einkristallinen Schicht deponiert wird und gleichzeitig oder anschließend eine Erwärmung der Schicht erfolgt, um durch thermische Diffusion und/oder chemische Reaktion eine Homogenisierung der gewünschten einkristallinen Schicht bzw. Bildung des Mischkristalls zu erzielen.

4. Verfahren nach Anspruch 1 oder 2,
**dadurch gekennzeichnet,**
daß die zur Bildung des Mischkristalls erforderliche Komponente durch Ionenimplantation und Glühbehandlung in die einkristalline Schicht eingebracht wird.

5. Verfahren nach Anspruch 4,
**dadurch gekennzeichnet,**
daß die Glühbehandlung der Ionenimplantation nachgeschaltet ist.

6. Verfahren nach Anspruch 1 oder 2,
dadurch gekennzeichnet,
daß die zur Bildung des Mischkristalls erforderliche Komponente auf der einkristallinen Schicht mittels Epitaxie abgeschieden wird und während oder nach der epitaktischen Abscheidung der Komponente eine Glühbehandlung vorgenommen wird.

7. Verfahren nach einem der vorhergehenden Ansprüche,
**dadurch gekennzeichnet,**
daß die Dicke der einkristallinen Schicht ermittelt und vor dem Hinzufügen der Komponente abgedünnt wird.

## Claims

1. Process for the manufacture of layered structures for microelectronic components, comprising a single crystal substrate with buried insulating amorphous layer and a single crystal layer thereon, based on a single crystal substrate with buried amorphous layer and single crystal layer thereon **characterised in that** the original single crystal layer is, by way of adding a component, completely converted into a mixed crystal which matches the desired singly crystal layer.

2. Process for the manufacture of layered structures for microelectronic components, comprising a single crystal substrate with buried insulating amorphous layer and single crystal layers thereon, based on a single crystal substrate with buried insulating amorphous layer and a single crystal layer thereon, **characterised in that** the original single crystal layer on the amorphous layer is, by way of adding a component, completely converted into a mixed crystal the grid parameters of which are closer to those of the desired single crystal layer than the grid parameters of the crystal layer converted into a mixed crystal, and thereafter the desired single crystal layer is precipitated on the mixed crystal.

3. Process according to Claim 1 or 2, **characterised in that** the component required for forming the mixed crystal is deposited on the single crystal layer, and simultaneously or subsequently the layer is heated in order to achieve, by way of thermal diffusion and/or chemical reaction, homogenisation of the desired single crystal layer or forming of the mixed crystal.

4. Process according to Claim 1 or 2, **characterised in that** the component required for forming the mixed crystal is incorporated in the single crystal layer by way of ion implantation and annealing treatment.

5. Process according to Claim 4, **characterised in that** the annealing treatment follows the ion implantation.

6. Process according to Claim 1 or 2, **characterised in that** the component required for forming the mixed crystal is precipitated on the single crystal layer by means of epitaxy, and an annealing treatment is carried out during or after the epitaxy separation of the component.

7. Process according to one of the above claims, **characterised in that** the thickness of the single crystal layer is determined and thinned down prior to adding the component.

## Revendications

1. Procédé pour fabriquer des structures à couches pour composants microélectroniques, constitué par un substrat monocristallin comportant une couche amorphe isolante ensevelie et une couche monocristalline située sur cette couche, à partir d'un substrat monocristallin comportant une couche amorphe ensevelie et une couche monocristalline située sur cette couche, caractérisé en ce que l'on convertit complètement la couche monocristalline initiale, en ajoutant un constituant, en un cristal mixte correspondant à la couche monocristalline désirée.

2. Procédé pour fabriquer des structures à couches pour composants microélectroniques, constitué par un substrat monocristallin comportant une couche amorphe isolante ensevelie et des couches monocristallines situées sur cette couche, à partir d'un substrat monocristallin comportant une couche amorphe ensevelie et une couche monocristalline située sur cette couche, caractérisé en ce que l'on convertit complètement la couche monocristalline initiale située sur la couche amorphe, en ajoutant un constituant, en un cristal mixte, dont les paramètres du réseau sont plus proches de ceux de la couche monocristalline désirée que ne le sont les paramètres du réseau de la couche cristalline convertie en le cristal mixte, à la suite de quoi on dépose la couche monocristalline désirée sur le cristal mixte.

3. Procédé selon la revendication 1 ou 2, caractérisé en ce qu'on dépose le constituant nécessaire pour la formation du cristal mixte sur la couche monocristalline et qu'on effectue simultanément ou ensuite un échauffement de la couche pour obtenir, par diffusion thermique et/ou réaction chimique, une homogénéisation de la couche monocristalline désirée ou la formation du cristal mixte.

4. Procédé selon la revendication 1 ou 2, caractérisé en ce qu'on insère le constituant, qui est nécessaire pour la formation du cristal mixte, par implantation ionique et traitement de recuit, dans la couche moncristalline.

5. Procédé selon la revendication 4, caractérisé en ce que le traitement de recuit est exécuté après l'implantation ionique.

6. Procédé selon la revendication 1 ou 2, caractérisé en ce qu'on dépose par épitaxie le constituant, qui est nécessaire pour la formation du cristal mixte, sur une couche monocristalline et qu'on exécute un traitement de recuit pendant ou après le dépôt épitaxial du constituant.

7. Procédé selon l'une des revendications précédentes, caractérisé en ce qu'on détermine l'épaisseur de la couche monocristalline et qu'on la réduit avant d'ajouter, le constituant.
